# EUROPEAN PATENT SPECIFICATION

(11) **EP 0 420 836 B1**
(45) Date of publication and mention of the grant of the patent: **15.02.1995**
(21) Application number: 87904645.6
(22) Date of filing: 06.07.1987
(51) Int. Cl.: H03K 5/19, H03K 5/22, G08B 21/00, G05B 13/04, D04B 15/66

(54) **IMPROVED MONITORING METHODOLOGY**
Signalüberwachungsverfahren
METHODOLOLGIE AMELIOREE DE SURVEILLANCE

(30) Priority: 07.07.1986 SE 8603005
(43) Date of publication of application: 10.04.1991
(73) Proprietor: B.T.S.R. International S.p.A., I-21052 Busto Arsizio (VA) (IT)
(72) Inventor: RYDBORN, Sten-Ake Olaus, S-343 00 Älmhult (SE)
(74) Representative: Giambrocono, Alfonso, Dr. Ing.
(86) International application number: SE8700320
(87) International publication number: WO8800412

(56) References cited:
- EP-A- 0 026 425
- WO-A-85/05511
- DE-C- 2 644 646
- US-A- 3 457 552
- US-A- 3 581 281
- US-A- 3 594 585
- US-A- 3 623 015
- US-A- 3 652 943
- US-A- 3 725 875
- US-A- 3 831 039

## Description

The present invention relates to a method for monitoring that a plurality of mutually subsequent signals have substantially the same appearance and, thereby, are substantially alike, and for triggering an alarm and/or stop function on signal loss and/or the occurrence of one or more unknown and unacceptable deviations in the monitored signal, and for preventing tiggering of an alarm and/or stop function on the occurrence of one or more known and acceptable deviations in the appearance of the monitored signal.

In many contexts, it is fraught with serious problems to monitor electric signals which correspond, for instance, to thread movements in different types of machines, such as looms, since, in the continuous signals, there may occur signal gaps which are acceptable and are to be ignored. The most common monitoring method is to monitor that the signals' continuity is not broken. Furthermore, it is extremely difficult to pinpoint the occurrence of one or more signal gaps in the otherwise continuous signal, since this gap or these gaps do not always occur at the same position in the signal, but instead the occurrence of the signal gap or gaps has proved to be dependent on such factors as machine type, thread variety, thread quality etc. This has led to extremely complicated adjustment and fine-tuning problems, as well as extensive post-installation adjustments.

WO 85/05511 describes a pulse detector suitable for detecting missing or extra pulses which are generated by a sensor, for example of the Hall type, located close to a rotating wheel. The latter has a number of equally spaced projecting teeth and a missing tooth location, and is fixed to a crankshaft of an engine. The detection of the missing tooth enables the known device to detect a particular position of the crankshaft. The use of the pulse detector in any system in which the existence of a missing (or additional) pulse in a variable frequency pulse train is to be detected, is also described.

US-A-3,457,552 describes a system suitable for recognizing a pattern which has been previously "learned" by the system. The prior art document operates a learning phase on a well defined pattern such as alphabetic letters or information structures of all kinds including signals. The known system comprises, in particular, sensor means such as scanners and matrix of photoresistor cells or the like.

The task forming the basis of the present invention is to realise a method for obviating the above-outlined problems and drawbacks, or at least reducing them to an acceptable level.

This task is solved according to the present invention in that the method disclosed by way of introduction are given the characterising features as set forth in the appended claims.

As a result of the method according to the present invention, there will for realised an extremely simple methodology for reliable and dependable monitoring of a continuous signal, within which there may occur natural variations which are to be ignored, without the need arising for any extensive fine-tuning or adjustment difficulties on any appreciable scope. This is because the apparatus for performing the present invention may be considered as an autodidactic or self-learning monitoring circuit which, during a number of machine revolutions, learns the appearance of that signal which is to be monitored, since it may, with great probability, be assumed that the signal will continue to have the same appearance as it had during the so-called learning phase.

The method according to the present invention afford particular advantages in machines for knitting of different products, for instance socks. In this case, the signal from the thread or yarn movement sensors in each machine or pattern stage is memorized from the beginning of the product or the pattern to its end, whereafter the sensed and monitored signal is compared with the memorized signal. In this way, there will be achieved an extremely effective and efficient product quality control, whereby it will be assured not only that the thread, and possibly the threads, in each revolution are whole and unbroken, but also that the product is of the correct pattern and thread or yarn mix.

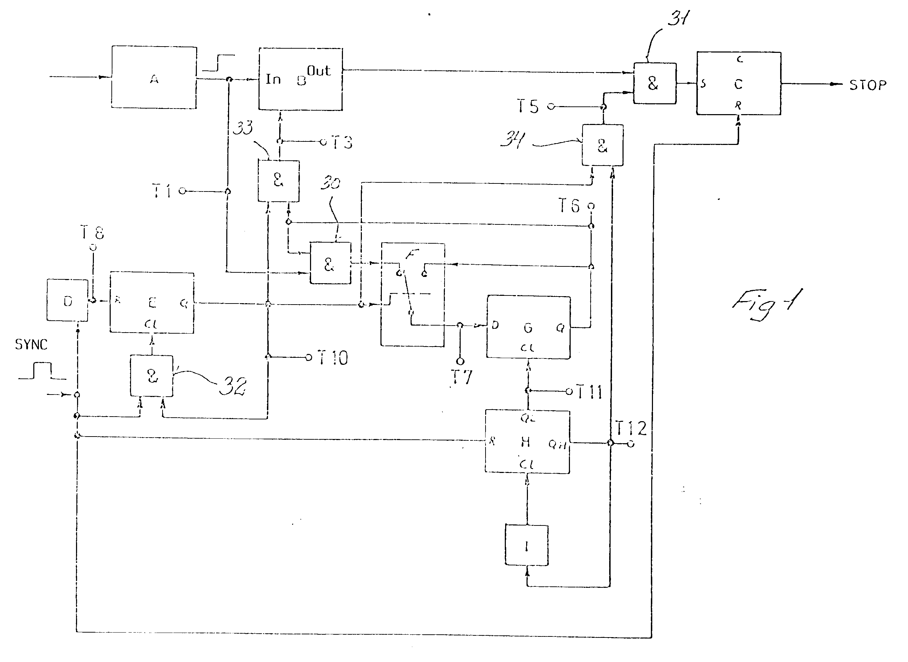

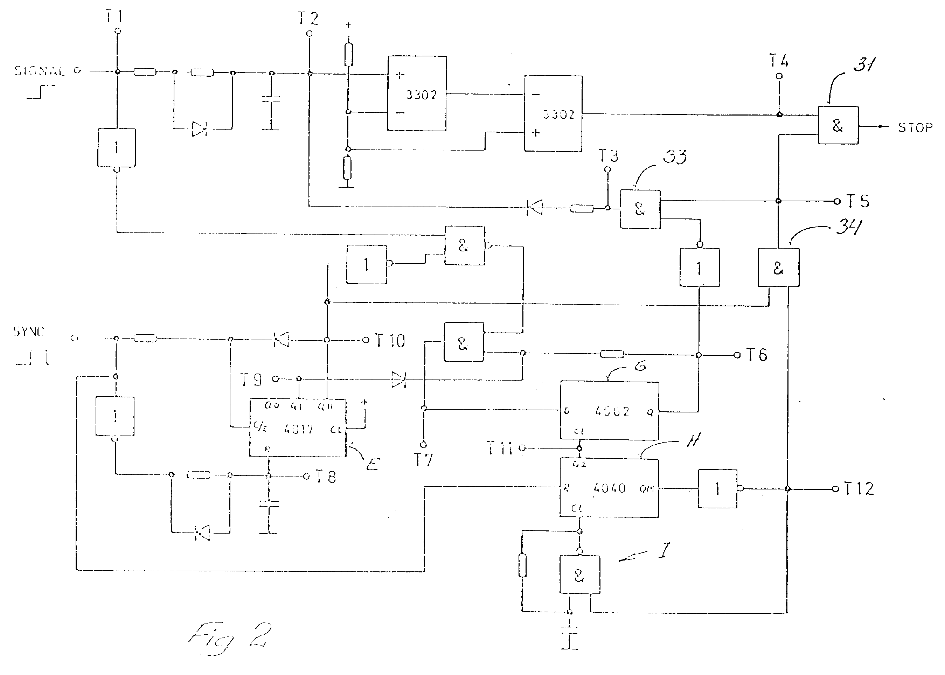

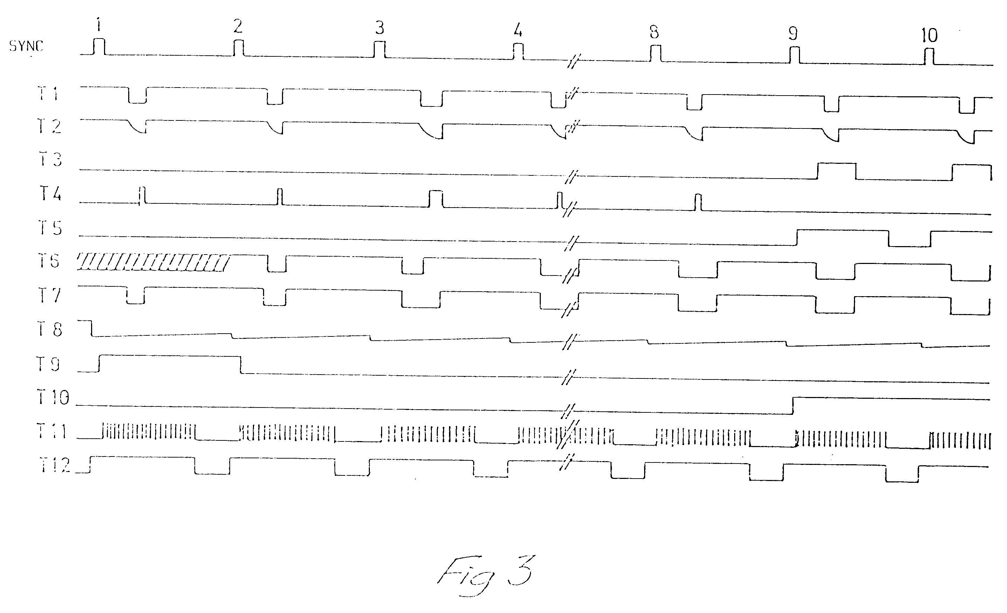

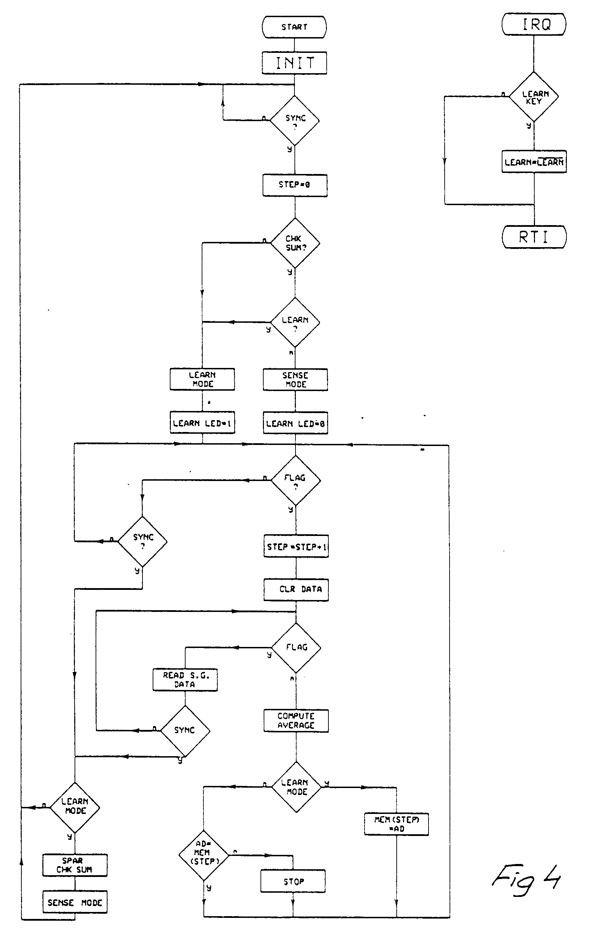

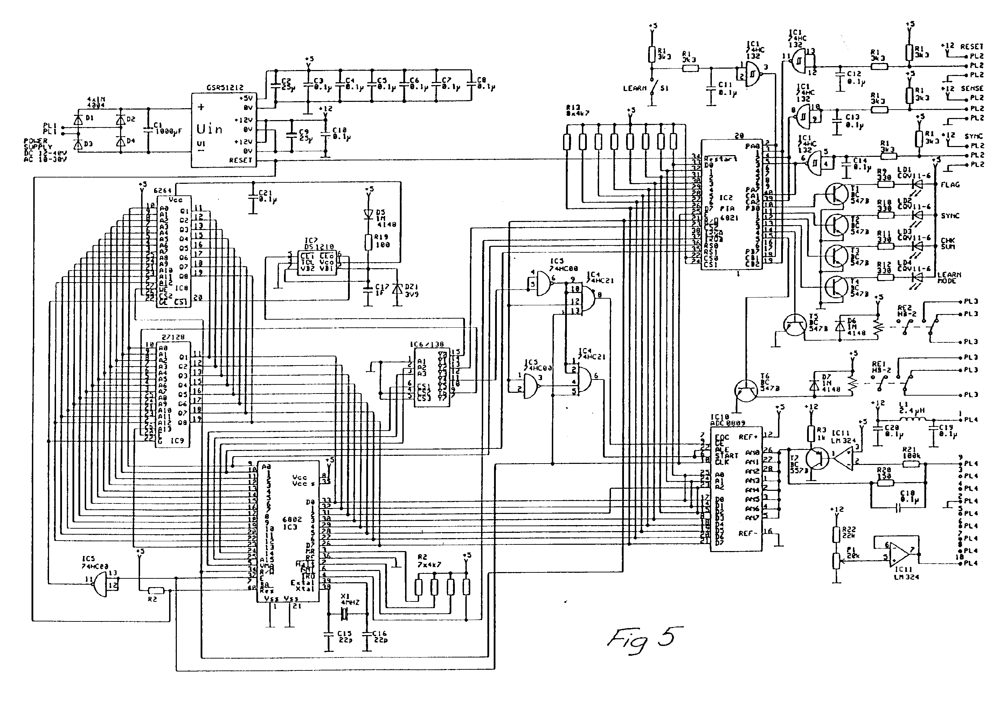

The present invention will be described in greater detail below with reference to the accompanying Drawings. Fig. 1 shows a block diagram of an apparatus for performing the present invention. Fig. 2 is an outline diagram of the apparatus illustrated in Fig. 1. Fig. 3 shows a pulse diagram of pulses from measurement points indicated in the block diagram and the outline diagram. Fig. 4 is a flow diagram of one physical application of the present invention. Fig. 5 is a block diagram of one embodiment for carrying out the practical application according to Fig. 4.

One embodiment of a method according to the present invention will now be described in greater detail with reference to the block diagram in Fig. 1, the outline diagram in Fig. 2 and the pulse diagram in Fig. 3. A signal emitter of some suitable type which, in response to, for example, the movement of a thread in a loom, generates an electric signal, is connected to a circuit A for amplification and digitalization of the signal. Suitably, the signal emitter may be of the piezoelectric type, but it is also concievable to employ other types of signal emitters. The amplification and digitalization circuit is coupled to a blocking circuit B and to an AND gate 30. The output of the blocking circuit B is coupled to an AND gate 31 whose output is coupled to an alarm and/or stop function trigger circuit C which may be a flip-flop, or one shot circuit of some suitable type and which may, in, for instance a loom, be caused to emit a stop signal to the loom on the occurrence of an output signal from the AND gate 31.

As has been mentioned earlier, there may occur, in the signal from the amplification and digitalization circuit A, normal and known and acceptable signal gaps. However, these gaps do not always occur at exactly the same position in the signal and it is necessary to inform, in one way or another, the monitoring circuit that it is to ignore such known, normal and acceptable signal gaps. In accordance with the illustrated embodiment of the apparatus performing the present invention, a synchronization pulse - hereinafter designated sync-pulse - emitter is coupled to a circuit D which may be considered as a filter for control of the presence of sync-pulses which indicate that the machine is in operation to an AND gate 32, to a counter circuit H and to the trigger circuit C. The output from the filter D is coupled to the reset input R of a counter circuit E, whose Q output is coupled to the AND gate 32, an AND gate 33 and an electronic switch F. The output of the AND gate 32 is coupled to the clock pulse input CL of the counter E, which is adjustable and operative to count a certain number of sync-pulses from start, before emitting an output signal on the output Q. The switch F is a so-called logic switch and its one input is coupled to the output from the AND gate 30 and its other input to the ouput from a shift register G, while the output of the switch F is coupled to the input D of the shift register G. The output of the shift register G is further coupled to the one input of the AND gates 30 and 33. The Q output of the counter circuit E is, moreover, coupled to the one input of an AND circuit 34. The clock pulse input of the shift register G is coupled to the QL output from the counter H whose reset inputs are coupled to the sync-pulse emitter and whose clock pulse input CL is coupled to a clock pulse generator I. The input of the clock pulse generator I is coupled to the output QH of the counter H and to the one input of the AND circuit 34. The output from the AND gate 33 is coupled to the-blocking input of the blocking circuit B.

The above-described embodiment of the present invention may suitably be applied to a loom of the type in which the thread is propelled in through the shed by means of a projectile, water jet, air jet or some other medium, is caught on the other side of the shed and is thereafter retracted a distance. During this retraction, it is desirable to sense whether the thread is whole or not. In such an event, as was mentioned above, one or more signal gaps will occur in the signal emitter of varying type both in amplitude and position. As will be apparent from the outline diagram according to Fig. 2, the signal evaluation circuit includes an RC link or loop between the measurement points T1 and T2, the capacitor being employed to permit certain variations in the signal, while if the variations become too great, a signal will occur on the output of the comparator which is inverted and fed further to the AND gate 31 and flip-flop C for stopping the machine. In order to avoid stopping the machine on the occurrence of known and acceptable gaps in the signal, a signal is fed via the AND gate 33 to the blocking circuit B which is to fill-out the known and normal, and accepatable gaps in the signal to the RC link, such that the capacitor therein will not have time to discharge and give rise to an output signal to the AND gate 31. The signal from the AND gate 33 is obtained with the assistance of the shift register G. As is particularly apparent in the pulse diagram in Fig. 3, the shift register learns, during the first eight machine revolutions or sync-pulses, where in the signal a signal gap occurs, and is caused to generate a signal corresponding to the signal gap for feeding to the blocking circuit B via the AND gate 33.

In the counter circuit E, the number of machine revolutions is set which is deemed to be necessary in order that the shift register G learn where in the signal T1 a signal gap or several signal gaps occur. The counter H determines the shift interval of the shift register G. During the sync-pulses 1-8, the counter circuit E holds the switch F in the position illustrated in Fig. 1, in which both the signal from the circuit A and the signal from the shift register G influence the output signal from the AND gate 30, such that the shift register takes account of all of the signals T1 occurring during the preceding 1-8 sync-pulses. At the ninth sync-pulse, the counter circuit E will throw the switch F to the opposite position in relation to that illustrated in Fig. 1. Thereafter, the shift register G will be deemed to have learnt the configuration or appearance of the signal which is to be monitored. Thereafter, the shift register contents will not be influenced until after a stop in the machine, whereupon a new learn phase may be initiated. Even if the signal T1 is shown as continuous in the pulse diagram according to Fig. 3, there is, naturally, nothing to prevent the occurrence of known and desired additional breaks therein between the sync-pulses over and above the illustrated discontinuation or break. One such additional break may be the end of the signal and, in certain applications, it may be desirable to monitor that the signal ends at the same position in every machine cycle.

The configuration, and thereby the appearance of the monitored signal may vary from thread quality to thread quality and from machine to machine, and furthermore threads of different colours may give different signal appearances, for which reason there is often provided, in a multi-coloured manufacturing machine, one apparatus of the type described in the foregoing for each thread variety and thread colour.

Furthermore, as illustrated in Figs. 4 and 5, one embodiment of the present invention may be applied on a machine for knitting of different types of products, for instance stockings or socks. Each one of the included threads is allocated an emitter which is operative to emit an electric signal on thread movement. Furthermore, the machine is provided with an emitter which is operative to generate an electric signal or flag pulse (designated "FLAG" in Figs. 4 and 5) and which defines a thread movement sensing period during one machine revolution, which may also be designated a pattern stage or knitting revolution. The term machine revolution may also be taken to refer to a machine cycle. The product which is to be knitted consists of a number of knitting cycles or pattern stages which together form the product and its pattern. The machine also includes an emitter which is operative to generate an electric signal or sync-pulse ("SYNC" in Figs. 4 and 5) on the commencement of each product, and thereby on the initiation of a new pattern.

The electronic coupling diagram illustrated in Fig. 5 is, in principle, self-evident to a person skilled in the Art and makes it possible for the skilled reader of this specification to reduce into practice an apparatus for monitoring the manufacture of stockings or socks in a knitting machine. Hence, Fig. 5 shows the hardware section, while Fig. 4 illustrates the software section or a flow diagram for the software section, which is also easy to reduce into practice according to generally accepted methods for a person skilled in this Art.

The hardware section according to Fig. 5 includes a number of integrated circuits 1-11 which are all currently available on the market. The integrated circuit IC3 is a micro-computer which is controlled by means of a program stored in the integrated circuit IC9, which is a read memory and contains the program requisite for the function of the circuit. The integrated circuit IC8 is a registration or memorization circuit. The integrated circuit IC10 is an AD converter, while the integrated circuit IC2 is both an input and output circuit. The integrated circuit IC7 is a battery back-up circuit for the registration circuit IC8, while the integrated circuit subunits IC4, IC5 and IC6 form decoder units. Otherwise, the symbols in the coupling diagram are of the generally accepted type. A switch S1 is connected to the input and output circuit IC2 for switching the apparatus to and from a learn mode or learn phase. Furthermore, there is connected, to the circuit IC2, a reset button "RESET", which, after actuation, always entails resetting of the electronic circuits and the program to the initial position. There is further coupled-in a sensor circuit "SENS" which receives a flag pulse which determines that period of time during which thread movement is to be sensed in each pattern stage or machine revolution. Moreover, a circuit unit "SYNC" is coupled to the input and output circuit IC2 for entry of a sync-pulse on commencement of each product. There are further connected to the input and output circuit IC2 a number of light emitting diodes (LEDs) LD1-LD4 for indicating the presence of a flag pulse, sync-pulse, check total CHK and learn mode, respectively. There are further coupled to the input and output circuit IC2 two relays RE1 and RE2. On the occurrence of a signal triggering an alarm and/or stop function, the relay RE1 entrains the lighting of an indication lamp or other type of signal emitter, while the relay RE2 entails stop of the machine.

All thread movement signal emitters included in the machine are coupled to the AD converter IC10 and, as will be apparent, all emitters are of the current emitter type, such that the more threads there are in movement on each sensing, the greater will be the current to the AD converter, and the lesser will be the digital signal departing from the AD converter. With no input emitter signal, the digital signal will be the output signal 255. Using the integrated circuit IC11 and the potentiometer P1, the sensitivity of the signal emitters may be regulated.

Taking the flow diagram in Fig. 4 as the point of departure, the operational mode of the above-described circuitry will be described. Apart from the major flow from "START" to "STOP", or the next pattern stage, there is also an "INTERRUPT" flow which is made operative on the intentional desire for a learn phase which is initiated on every second depression of the current switch or switch S1 in Fig. 5. How the learn phase proceeds is apparent in the major flow. When current has been turned on and a number of initial coupling checks have been executed, the apparatus waits for a sync-pulse, which is the start pulse proper.

As soon as a sync-pulse occurs, it is ascertained that the pattern stage 0 has been introduced. On condition that the check total is correct, it is queried whether there is to be carried out a learn phase or a normal sensing phase. Prior to the commencement of a completely new product, for example a sock, a learn phase must, naturally, always be carried out, in which the light emitting diode LD4 is lit. Irrespective of whether the apparatus is in its learn mode or sensing mode, during which latter the light emitting diode LD4 is extinguished, the apparatus awaits a flag pulse which entails that pattern stage 1 has been commenced and CLR cleared, the registration circuit or memory circuit IC8 (the computer circuits) are zeriozed. As long as there is a flag pulse, the signal from the AD converter IC10 is read at very short intervals, eg. 100 microseconds and these readings are stored or registered in the memory circuit IC8. When the flag pulse disappears and the pattern stage and machine revolution have been completed, the mean value of the read-offs executed during the pulse flag is calculated and, if the apparatus is in the learn mode (LEARN), the resultant mean value is registered. If, on the other hand, the apparatus is in the sensing mode, the thus resultant mean value is compared with the value previously memorized during a learn phase of the signal in the pattern stage under consideration. If the difference between the mean value arrived at during the sensing operation does not deviate by more than a certain predetermined number of units from the memorized value, the apparatus passes to the next pattern stage, but if the difference is greater, a signal which triggers an alarm or stop function is generated, whereby the relays RE1 and RE2 are energized. After the finish of a complete product or a complete sock, which is approved after inspection, there will be, in the registration or memory circuit IC8, a signal value for each pattern stage which is, in the sensing mode (SENSE), to be compared with the calculated mean value of the sensed signal on normal running operation.

While Fig. 4 illustrates an automatic switching to the learn mode if the check total is incorrect, it is difficult, in most cases, to carry out an automatic learn mode run. If the check total is incorrect, this should lead to a signal triggering an alarm and/or stop function. In principle, all learn mode runs must be monitored and the subsequently finished product must be inspected before switching to the sensing mode is executed.

After running of a learn phase or learn mode and approval of the thus produced product, the signals for each pattern stage are stored in the registration or memory circuit IC8 and the machine may be run for manufacture of identical products for several days, several weeks or several months, without the necessity of implementing a new learn phase.

Thus, in every pattern stage, there may be included any given number of threads or yarns, and also threads or yarns of different types, since the apparatus senses every pattern stage and ascertains whether the thread movements sensed during the manufacturing operation give a signal in the present pattern stage which had previously been obtained with a so-called master sock or the first-manufactured sock, or the sock produced during the learn phase. Since, in every machine revolution or every pattern stage, an immense number of sensing operations is carried out, and since it is the mean value of all sensings which is compared with the previously memorized signal, certain deviations in the signal are permitted without therefore giving rise to machine stop.

When reading the appended claims in relation to the above-illustrated practical application of the present invention, the term a plurality of mutually subsequent signals will be understood as the signal from one and the same pattern stage in mutually subsequent products, but it may, naturally, just as well relate to signals from several mutually subsequent pattern stages in the same product, when the pattern stages are alike and the registered signals for each respective pattern stage are substantially alike or do not differ from one another more than by the predetermined number of units permitted between registered signal and sensed signal, i.e. the calculated mean value of a number of sensings of one and the same signal.

## Claims

1. A method for monitoring a textile machine such as a loom or a knitting machine wherein a self-learning phase of the machine operational sequences is provided, during such a self-learning phase a textile master product is manufactured e.g. stockings or socks, during such a phase, signals generated by at least one yarn movement sensor being memorized in a memory stage of a registration circuit (IC8) from the beginning to the end of the product manufacturing cycle of the textile master product, said signals corresponding to each pattern stage of the latter, after the learning phase and the approval of the product by inspection further manufacturing operations being controlled by comparing signals generated by the at least one yarn movement sensor with corresponding memorized signals, such manifacturing operation being stopped when unknown deviations from the memorized signals occur, operation not being stopped when one or more acceptable deviations occurs.

2. A method as claimed in claim 1 characterized in that the self-learning phase is operated during a predetermined period of time corresponding to at least a part of one machine cycle in a textile machine, such as a knitting machine, said machine cycle corresponding to one knitting revolution in a knitted product or one pattern stage in the pattern for the knitted product.

3. A method as claimed in claim 1, characterized in that the control of the commencement of each knitting revolution in a knitted product or one pattern stage is provided, such a control being provided for detecting the operation of the textile machine.

## Patentansprüche

1. Verfahren zum Überwachen einer Textilmaschine wie ein Webstuhl oder eine Strickmaschine, bei dem eine Selbstlernphase für die Maschinenbetriebsabläufe vorgesehen ist, wobei während einer solchen Selbstlernphase eine Textilvorlage hergestellt wird, beispielsweise Strümpfe oder Socken, wobei während einer solchen Phase Signale von mindestens einem Garnbewegungssensor erzeugt werden, die in einer Speicherstufe einer Aufzeichnungsschaltung (IC8) vom Anfang bis zum Ende des Produktherstellungszyklus der Textilvorlage gespeichert werden, wobei die Signale jeder Musterstufe der letzteren entsprechen, wobei nach der Lernphase und der Absegnung des Produkts durch Begutachtung weitere Herstellungsvorgänge gesteuert werden, indem Signale verglichen werden, die von dem mindestens einen Garnbewegungssensor erzeugt und mit entsprechend gespeicherten Signalen verglichen werden, wobei der Herstellungsvorgang angehalten wird, wenn unbekannte Abweichungen von den gespeicherten Signalen auftreten, während der Vorgang nicht gestoppt wird, wenn eine oder mehrere akzeptable Abweichungen erfolgen.

2. Verfahren nach Anspruch 1, **dadurch gekennzeichnet**, daß die Selbstlernphase während einer vorgegebenen Zeitspanne durchgeführt wird, die zumindest einem Teil eines Maschinenzyklus in einer Textilmaschine entspricht, beispielsweise einer Strickmaschine, wobei der Maschinenzyklus einer Strickumdrehung bei einem gestrickten Produkt oder einer Musterstufe im Muster für das gestrickte Produkt entspricht.

3. Verfahren nach Anspruch 1, **dadurch gekennzeichnet**, daß die Steuerung des Beginns von jeder Strickumdrehung bei einem gestrickten Produkt oder eine Musterstufe vorgesehen wird, so daß eine Steuerung vorgesehen ist, um den Betrieb der Textilmaschine zu erkennen.

## Revendications

1. Procédé de surveillance d'une machine textile telle qu'un métier à tisser ou une machine à tricoter, procédé qui prévoit une phase auto-adaptative aux séquences opérationnelles de la machine, la fabrication, au cours d'une telle phase auto-adaptative, d'un produit textile modèle, par exemple des bas ou soquettes, des signaux, engendrés par au moins un détecteur des mouvements du fil étant mémorisés au cours d'une telle phase dans un étage mémoire d'un circuit d'enregistrement (IC8), du début à la fin du cycle de fabrication du produit textile modèle, lesdits signaux correspondant aux différents éléments de motif de ce dernier, les opérations suivant la phase adaptative et l'approbation du produit par inspection étant commandées en comparant des signaux engendrés par au moins un détecteur du mouvement du fil avec des signaux correspondants mémorisés, la fabrication étant arrêtée lorsque des écarts non prévus par rapport aux signaux mémorisés se produisent, l'opération n'étant pas interrompue s'il se produit un ou plusieurs écarts acceptables.

2. Procédé selon la revendication 1,
caractérisé en ce que la phase auto-adaptative a lieu pendant un laps de temps prédéterminé correspondant à au moins une partie d'un cycle machine d'une machine textile telle qu'une machine à tricoter, ledit cycle correspondant à un tour tricoté d'un produit tricoté ou à un élément de motif d'un produit tricoté à motifs.

3. Procédé selon la revendication 1,
caractérisé en ce que la commande du début de chaque tour de tricot d'un produit tricoté ou d'un élément de motif est prévue, une telle commande étant prévue pour détecter l'opération de la machine textile.
